# EUROPEAN PATENT SPECIFICATION

(11) **EP 1 804 289 B1**
(45) Date of publication and mention of the grant of the patent: **23.11.2011**
(21) Application number: 06026787.9
(22) Date of filing: 22.12.2006
(51) Int. Cl.: H01L 21/8247, H01L 27/115, G03F 1/14, H01L 21/768

(54) **Non volatile memory electronic device integrated on a semiconductor substrate**
In ein Halbleitersubstrat integrierte elektronische Vorrichtung mit nichtflüchtigem Speicher
Dispositif électronique de mémoire non volatile intégré sur un substrat semi-conducteur

(30) Priority: 30.12.2005 EP 05425940
(43) Date of publication of application: 04.07.2007
(73) Proprietor: STMicroelectronics Srl, 20041 Agrate Brianza (MB) (IT)
(72) Inventor: Servalli, Giorgio, 24040 Ciserano (Bergamo) (IT); Capetti, Gianfranco, 24010 Sorisole (Bergamo) (IT); Cantú, Pietro, 23900 Lecco (IT)
(74) Representative: Niederkofler, Oswald

(56) References cited:
- EP-A- 0 766 316
- US-A- 6 157 575
- US-B1- 6 441 427
- US-B1- 6 777 957

## Description

### Field of application

The present invention relates to a non volatile-memory electronic device integrated on a semiconductor substrate.

More specifically the invention relates to a semiconductor integrated non volatile memory device comprising a matrix of non volatile memory cells organised in rows, called word lines, and columns, called bit lines, the device comprising:
- a plurality of active areas formed on the semiconductor substrate comprising a first and a second group of active areas,
- said non volatile memory cells being integrated in said first group of active areas, each non volatile memory cell comprising a source region, a drain region and a floating gate electrode coupled to a control gate electrode, at least one group of said memory cells sharing a common source region integrated on said semiconductor substrate.

The invention particularly, but not exclusively, relates to a non volatile memory device of the Flash type and the following description is made with reference to this field of application by way of illustration only.

### Prior art

As it is well known, non volatile memory electronic devices, for example of the Flash type, integrated on semiconductor substrate comprise a matrix of non volatile memory cells which are organised in rows, called word lines, and columns, called bit lines.

Each single non volatile memory cell comprises a MOS transistor wherein the gate electrode, placed above the channel region, is floating, i.e. it shows a high DC impedance towards all the other terminals of the same cell and of the circuit wherein the cell is inserted.

The cell also comprises a second electrode, called control gate, which is capacitively coupled to the floating gate electrode through an intermediate dielectric layer, so called interpoly. This second electrode is driven through suitable control voltages. The other electrodes of the transistor are the usual drain, source terminals.

The cells coupled to a same word- line share the electric line which drives the respective control gates, while the cells coupled to a same bit line share the drain terminals.

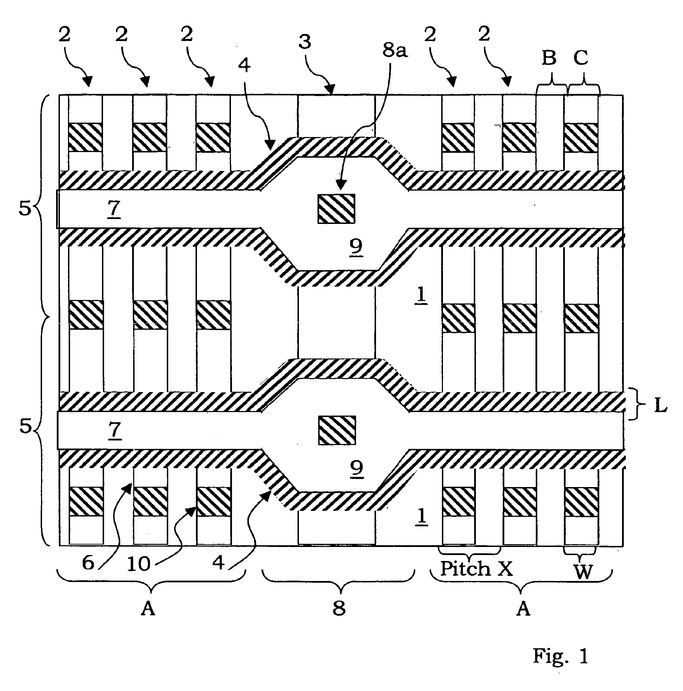

An architecture for non volatile memory matrixes of the NOR type is, for example, shown with reference to figure 1.

In particular, on a semiconductor substrate 1 a plurality of active areas 2 are realised wherein the memory cells will be formed. Groups A of active areas, wherein the active areas 2 are equidistant from each other, are separated by active areas 3 of greater dimensions with respect to the active areas 2 and more spaced from these groups A of active areas.

In particular, the active areas 2 of the group A have a same width B and adjacent active areas 2 are spaced by a same distance C. The sum of the width B and of the distance C defines the pitch of the memory matrix, conventionally indicated as pitch X.

Each active area 2, 3 is surrounded by an oxide layer called field oxide.

After having formed at least one tunnel oxide layer and a first polysilicon layer on the semiconductor substrate 1, in this polysilicon layer, the floating gate electrodes of the memory cells 6 are then defined having width W along a first direction.

After having formed at least one interpoly layer and one second polysilicon layer on the whole memory matrix, the second polysilicon layer, the interpoly layer, the first polysilicon layer and the oxide layer are etched in sequence, through a photolithographic mask until the semiconductor substrate 1 is exposed and the gate electrodes of the memory cells 6 having length L are completed.

In particular, with this latter etching step, in the second polysilicon layer, word lines 4 of the matrix of memory cells 6 are defined. The portions of word lines aligned to- the floating gate electrodes form control gate electrodes of the- single memory cells 6.

In matrixes of memory cells with NOR architecture, groups 5 of memory cells 6 share a common source region 7. This common source region 7 is obtained by removing a portion of the oxide layer between the adjacent active areas and carrying out a dopant implantation in the semiconductor substrate 1.

To avoid a too high resistance of the common source region 7, the matrix of cells is interrupted at regular intervals (each 16 cells, or each 32 cells) for inserting a contact region 8 at the interconnection with the common source region 7. This contact region 8 is formed in correspondence with the active area 3 which has been provided with greater dimensions with respect to the active areas 2 wherein the single memory cells have been formed. In fact to allocate the contact region 8 without electric interference problems, the source region 7 will have to provide a pad 9 widened in correspondence with this contact region 8. A source contact 8a is then formed in correspondence with the widened pad 9 for contacting the active area 3 of greater dimensions and the common source region 7.

Also the polysilicon layer forming the word lines 4 must thus provide a particular shaping, for allowing the insertion of the widened pad 9 as shown in figure 1.

In fact memory devices of the NOR type with high density are generally designed with SAS architecture (Self Aligned Source) to reduce the dimension of the memory cell 6. Therefore the common source region 7 is self-aligned to the word lines 4 and thus the word lines 4 follow the profile of the widened pad 9.

After having formed drain regions of the memory cells 6 inside the active areas 2, drain contacts are formed 10 aligned to each other, while the source contact 8a is formed in correspondence with the widened pad 9.

Although advantageous under several aspects, these device show several drawback.

The continuous reduction of the dimension of the memory cells 6 and inparticular the continuous reduction of the pitch of the masks to form the active areas and the floating regions prevents the formation of the contact region 8 with the same pitch X of the cells, since there is no way to insert the shaping of the wordline 4 without reducing, in a non sustainable way, the dimension of the second polysilicon layer or the distance between the contact region 8 and the polysilicon layer itself.

In consequence not only the space dedicated to the contact region 8 is to be increased with respect to the space of a memory cell, but the regularity of the matrix pitch in correspondence with the contact region 8 is also to be interrupted.

From the lithographic point of view this interruption of the matrix pitch is a problem, especially if, for forming the photolithographic masks to be used in the manufacturing process of the memory device, lithographic lightning techniques called Off-Axis are used which are particularly dedicated to the definition of regular matrixes formed by lines and spaces. These lightning techniques, necessary when the pitch X becomes comparable or lower than the wavelength of the radiation used to defined structures on the semiconductor substrate, show a significant degrade of their performances each time when the regularity of the structures to be defined is interrupted.

As regards the formation of the contact region 8, two technical problems are identified:
- the breakage of the periodicity of the definition of the active areas 2 complicates the possibility of proximity corrections to be applied to the masks for obtaining the desired dimensions. In particular, it is difficult to form active areas 2 adjacent to the widest active area 3 having the same dimensions as the other active areas 2 of the memory matrix,
- the breakage of the periodicity generates a structure being highly sensitive to the aberrations of the projection optical system. These distortions impact in an asymmetric way onto the control of the critical dimensions of the memory cells 6, therefore bitlines being nominally identical on mask are of different dimension on wafer, with consequences also on the dimensions of the adjacent spaces, and possible problems in filling in the field oxide region.

US 6,441,427 B1 provides a device in which trenches are formed by using stripe-form patterns with the same width and the same interval as a mask in the surface area of a silicon substrate and element isolation regions of STI structure are formed by filling insulating films into the trenches. Further, slits for isolating floating gates are formed by etching a polysilicon layer by using stripe-form patterns as a mask. In addition, control gates (word lines) are formed by using stripe-formed patterns as a mask.

EP 0 766 316 A1 shows a non volatile memory array which has a plurality of diffused horizontal source lines, each source line positioned between a pair of parallel horizontal stack conductors and connected to at least one common vertical source conductor including continuous diffused regions under each of said pairs of parallel stack conductors. In addition, the common vertical source conductor includes a metal conductor coupled to the continuous diffused regions at contacts located between the pairs of parallel stack conductors.

US 6,777,957 B 1 discloses an apparatus for testing a dielectric property of a material constituting the interlayer dielectric of a flash memory which is formed by a layer of the dielectric material and a plurality of conductors disposed within that layer or a pair of planar conductors deposited such that the conductors are substantially parallel to each other and the layer of dielectric material is disposed throughout a test structure so as to separate the conductors, the test structure functioning as a capacitor.

Finally, US 6,157,575 A provides a memory device having a plurality of cells, each including a stacked gate structure of a floating gate and a control gate. The cells are formed in an area where a plurality of bit lines arranged in parallel at specific intervals perpendicularly intersect a plurality of word lines arranged at specific intervals and include a plurality of source lines, each being arranged in parallel with the bit lines. Two cells symmetrically arranged with respect to each other and connected to the same bit line via respective bit line contacts share one active source region.

The technical problem underlying the present invention is that of providing a non volatile memory electronic device, having such structural characteristics as to allow to simplify the lithographic definition of the critical masks in matrix.

### Summary of the invention

The solution idea underlying the present invention is that of forming the active areas of the matrix of memory cells so that they are equidistant from each other and advantageously have the same dimensions.

The technical problem is solved by a memory device as defined by the subject-matter of claim 1. Embodiments are set forth in the dependent claims, the following description and the drawings.

The characteristics and the advantages of the device according to the invention will be apparent from the following description of an embodiment thereof given by way of indicative and non limiting example with reference to the annexed drawings.

### Brief description of the drawings

In these drawings:
- figure 1 shows a top schematic view of a portion of memory electronic device formed according to the prior art;
- figure 2 shows a top schematic view of a portion of a first embodiment of the memory electronic device formed according to the invention;
- figure 3 shows a top schematic view of a portion of a photolithographic mask used during a step of a process for manufacturing the memory electronic device of figure 2.
- figure 4 shows a top schematic view of a portion of a first embodiment -of the memory electronic device according to- the invention;
- figure 5 shows a top schematic view of a portion of a photolithographic mask used during a process for manufacturing the memory electronic device of figure 4.

### Detailed description

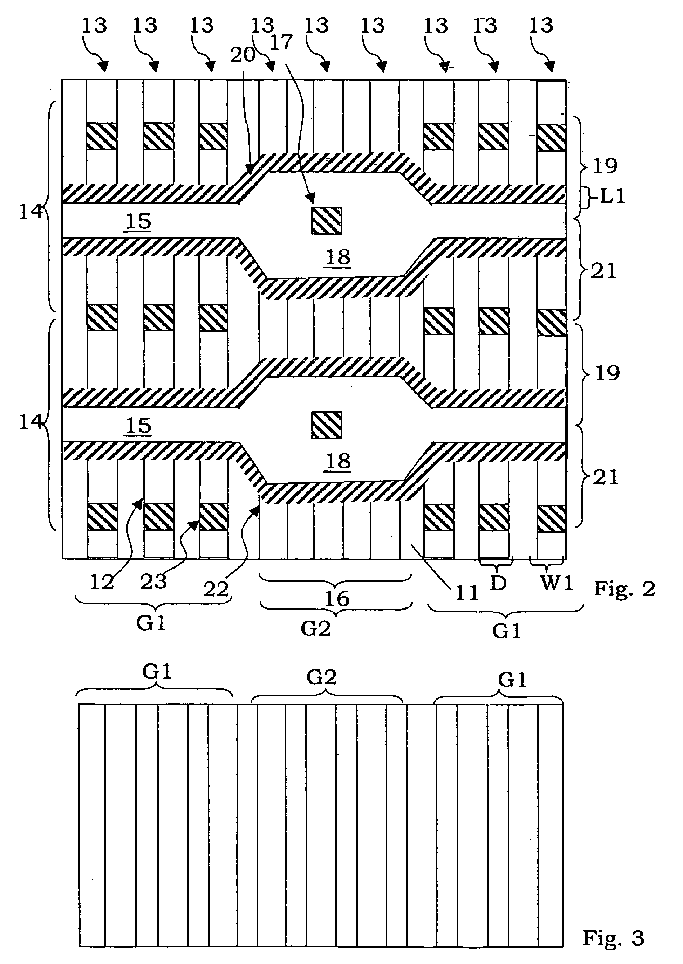

With reference to figures 2 to 5, a non volatile memory electronic device is described.

The process steps and the structures described hereafter do not form a complete process flow for the manufacturing of integrated circuits.

The figures showing cross sections of portions of an integrated circuit during the manufacturing are not drawn to scale, but they are instead drawn so as to show the important characteristics of the invention.

The present invention can be put into practice together with the manufacturing techniques of integrated circuits being currently used in the field, and only those commonly used process steps being necessary for the comprehension of the present invention are included.

In particular, with reference to figure 2, a first embodiment is described of a non volatile memory device integrated on a semiconductor substrate 11 and comprising a memory matrix formed by a plurality of non volatile memory cells 12 which are organised in rows, called word lines, and columns, called bit lines. In particular, in the memory matrix a plurality of active areas 13 are formed on the semiconductor substrate 11.

Each active area 13 is at least partially surrounded by a dielectric layer called field oxide.

According to the invention, these active areas 13 are equidistant from each other. For example, they are strips parallel to each other, and they have a same width D.

In a first group G 1 of active areas 13, non volatile memory cells 12 are formed, each non volatile memory cell 12 comprising a source region, a drain region and a floating gate electrode coupled with a -control gate electrode.

According to the invention, a second group G2 of active areas 13 are integrated in a contact region 18.

In the device according to the invention, at least one first group 14 of memory cells 12 shares a common source region 15 integrated on the semiconductor substrate 11.

In particular, pairs of cells 12 formed on the same active areas 13 and arranged symmetrically with respect to the common source region 15 share a same source region, the source regions of the memory cells 12 of the same group 14 of memory cells being electrically connected to one another by the common source region 15.

This common source region 15 is obtained, in a conventional way, by removing a portion of the oxide layer between adjacent active areas 13 and carrying out a dopant implantation in the semiconductor substrate 11.

To avoid a too high resistance of the common source region 15, the matrix of cells is interrupted at regular intervals (each 16 cells, or each 32 cells) for inserting the contact region 16 at the interconnection with the common source region 15.

Therefore, in the matrix of memory cells 13, first groups G1 of active areas and second groups G2 of active areas are alternated.

Advantageously according to the invention, the contact region 16 is formed in correspondence with at least three adjacent active areas 13 inside the second group G2 of active areas. In fact, to locate a source contact 17 inside the contact region 16 without problems of electric interference, the common source region 15 will have to provide a pad 18 widened in correspondence with this contact region 16. In particular, the widened pad 18 has a polygonal shape which is distributed inside the contact region 16 and it is in electric contact with the three active areas being inside the contact region 16.

Advantageously, the source contact 17 is formed in- correspondence with the central active area comprised inside the contact region 16, while the two adjacent active areas 13 only serve to maintain the regularity of the matrix.

In this embodiment of the device according to the invention the pitch of the memory matrix, i.e. the pitch X, can thus be maintained perfectly constant.

Moreover, inside the first group 14 of memory cells a second and a third group of memory cells can be identified.

The second group 19 of memory cells arranged above the common source region 15, and formed in different active areas share a first word line 20. This word line 20, in particular, connects the control electrodes of the memory cells of the second group 19 of memory cells.

The third group 21 of memory cells, arranged below the common source region 15, and formed in different active areas, share a second word line 22. This word line 22, in particular, connects the control electrodes of the memory cells of the third group 21 of memory cells.

The word lines 20, 22 must thus provide a particular shaping, inside the contact region 16 to allow the insertion of the widened pad 18 and of the source contact 17.

As noted in fact with reference to the prior art, memory devices of the NOR type with high density are generally projected with SAS architecture (Self Aligned Source) to reduce the dimension of the memory cell 12. Therefore the common source region 15 and the widened pad 18 are formed as self-aligned to the word lines 20, 22 and thus the word lines 20, 22 must be formed so as to follow the profile of the widened pad 9.

In-a conventional way, after having-formed drain regions of the memory cells 12 inside the active areas 13, drain-contacts 23 are formed being aligned to each other, while as already noted, the source contact 17 is formed inside the contact region 16, in particular in correspondence with the central active area and it is aligned to the common source region 15 along the first direction.

Clearly, the drain regions of the memory cells 12 are not formed in correspondence inside the active areas 13 which are comprised in the contact region 16.

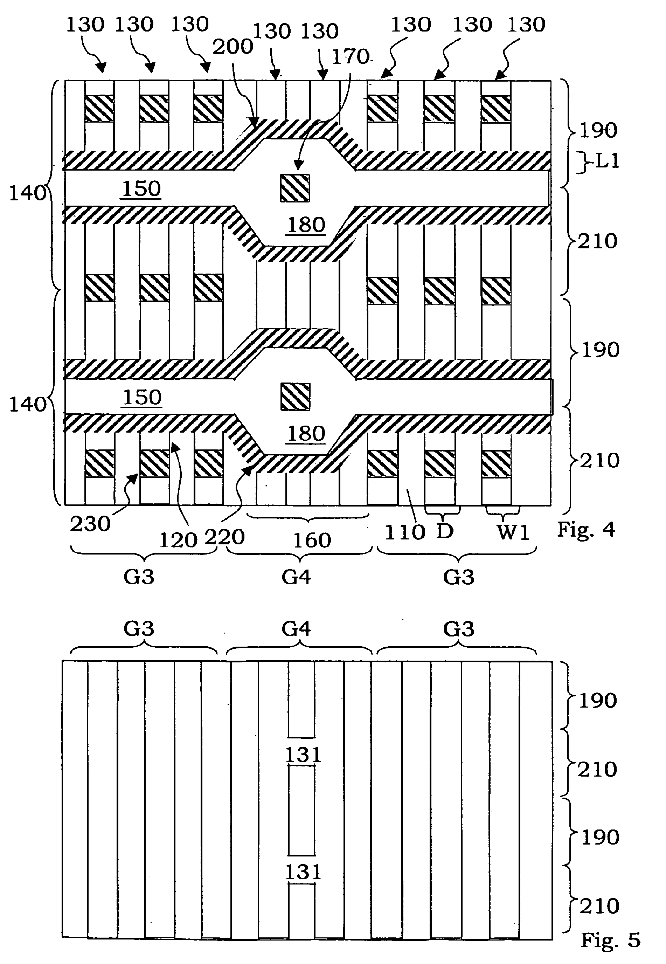

With reference to figure 4, a second embodiment of a non volatile memory device integrated on a semiconductor substrate 10 is described comprising a memory matrix formed by a plurality of non volatile memory cells 120 which are organised in rows, called word lines, and columns, called bit lines. In particular, in the memory matrix a plurality of active areas 130 are formed on the semiconductor substrate 110.

Each active area 130 is at least partially surrounded by a dielectric layer called field oxide.

According to the invention, these active areas 130 are equidistant from each other. For example, they are strips parallel to each other extending in a first direction, and they have a same width D 1.

In a first group G3 of active areas 130, non volatile memory cells 120 are formed, each non volatile memory cell 120 comprising a source region, a drain region and a floating gate electrode coupled to a control gate electrode.

According to the invention, in a second group G4 of active areas 130 a contact region 180 is integrated.

Advantageously, according to this second embodiment of the non volatile memory device according to the invention, at least one pair of active areas of the second group G4 of active areas is short-circuited among them.

In a known way, these active areas 130 are formed by means of a photolithographic technique which provides the use of a photolithographic mask, for example as the one shown in figure 5.

In particular, at least between a pair of adjacent active areas 130 of the second group G4 of active areas, there is at least one conductive interconnection portion 131 so as to short-circuit them.

In particular, the conductive interconnection portion 131 is formed by a portion of semiconductor substrate 110 comprised between at least the pair of active areas 130, wherein the field oxide layer has not been formed.

In the device according to the invention a first group 140 of memory cells shares a common source region 150 integrated in the semiconductor substrate 110.

In particular the portion 131 of the semiconductor substrate 110 comprised within this pair of cells 130 of the second group G4 of active areas is aligned to the common source region 150 along the first direction.

Moreover, pairs of cells 120 formed in the same active area 130 and arranged symmetrically with respect to the common source region 150 share a same source region, the source regions of the memory cells 120 of the first group 140 of memory cells being electrically connected to each other by the common source region 150.

This common source region 150 is obtained, in a conventional way, by removing a portion of the oxide layer between adjacent active areas 13 and by carrying out a dopant implantation in the semiconductor substrate 11.

To avoid a too high resistance of the common source region 150, the matrix of cells is interrupted at regular intervals (each 16 cells, or each 32 cells) for inserting the contact region 160 at the interconnection with the common source region 150.

As already highlighted, advantageously according to the invention, this contact region 160 is formed in correspondence with the two adjacent active areas 130 short-circuited with each other. In fact to allocate a source contact 170 inside the contact region 160 without electric interference problems, the common source region 150 will have to provide a pad 180 widened in correspondence with this contact region 160. In particular, the widened pad 180 has a polygonal shape which is distributed inside the contact region 160 and is in electric contact with the two active areas inside the contact region 16. The source contact 170 is then formed in correspondence with the portion 131 of the semiconductor substrate 110 comprised within this pair of adjacent cells 130.

Moreover, inside the first group 140 of memory cells a second and a third group of memory cells can be identified.

The second group 190 of memory cells arranged above the common source region 150, and formed in different active areas share a first word line 200. This word line 200, in particular, connects the control electrodes of the memory cells of the second group 190 of memory cells.

The third group 210 of memory cells, arranged below the common source region 150, and formed in different active areas, share a second word line 220. This word line 220, in particular, connects the control electrodes of the memory cells of the third group 210 of memory cells.

So, the word lines 200, 220 must be provided with a particular shaping, inside the contact region 160 to allow the insertion of the widened pad 180 and of the source contact 170.

As in fact noted with reference to the prior art, memory devices of the NOR type with high density are generally designed with SAS architecture (Self Aligned Source) to reduce the dimension of the memory cell 120. Therefore the source region 150 and the widened pad 180 are formed as self-aligned to the word lines 200, 220 and thus-the word lines 200, 220 must be formed so as to follow the profile of the widened pad 90.

In a conventional way, after having formed drain regions of the memory cells 120 inside the active areas 130, drain contacts 230 are formed being self-aligned, while, said source contact 170 is formed in correspondence with portions 131 of the semiconductor substrate 110 comprised within this pair of adjacent cells 130.

Clearly, the drain regions of the memory cells 120 are not formed inside the active areas 130 of the second group G4 of active areas.

In this embodiment the contact region 160 shows a double space with respect to the space of the single cell, i.e. the pitch X of the matrix.

Also in this embodiment, the matrix periodicity is substantially maintained, since the impact of the portions 131 which are used for allocating the source contact 170 is minimal.

A process is now described for manufacturing non volatile memory electronic device integrated on a semiconductor substrate 11, 110, for example of the P type.

In a conventional way active areas 13, 130 of memory cells 12, 120 are formed by means of a process comprising the steps of:
- forming, in cascade, a dielectric layer, for example of silicon oxide and a protective layer, for example of silicon nitride on the semiconductor substrate 11, 110,
- selectively removing the layers of silicon nitride and silicon oxide by means of a photolithographic technique which provides the use of a first photolithographic mask, for forming active areas 13, 130 for the memory cells 120,
- removing a part of semiconductor substrate using the same first photolithographic mask forming trenches which separate different, non removed regions of the nitride layer,
- oxidising the surface of the exposed semiconductor -substrate and filling in the trenches in the semiconductor substrate with a dielectric layer, for example of field oxide,
- planarising the surface by means of CMP technique (chemical mechanical polishing) for removing the dielectric layer formed above the silicon nitride layer,
- removing the silicon nitride layer and the underlying oxide layer for o uncovering the surface of the active areas 13, 130 for the memory cells 12, 120.

For example, a photolithographic mask used to form the active areas 13 of the first embodiment of the device according to the invention is shown in figure 3, while a photolithographic mask used to form active areas 130 of the second embodiment of the device according to the invention is shown in figure 5.

According to the invention, these active areas 13, 130 are equidistant from each other.

Advantageously, these active areas 13, 130 are strips being parallel to each other and extending in a first direction, being equidistant and having a same width D.

In a first group G1, G3 of the active areas 13, 130, the non volatile memory cells 12, 120 will be integrated, in a second group G2, G4 of the active-areas 13, 130 a contact region 180, 180 is integrated.

In the first embodiment of the device according to the invention the second group G2 of active areas comprises at least three adjacent active areas.

In the second embodiment of the device according to the invention the second group G4 of active areas comprises at least one pair of adjacent active areas short-circuited with each other. In particular, in at least one interconnection portion 131 of the semiconductor substrate 110, which contacts this pair of active areas, the field oxide layer which insulates the active areas from each other is not formed, therefore the interconnection portion 131 short-circuits the pair of active areas it is in contact with.

In sequence on the whole semiconductor substrate 11, 11, at least a first dielectric layer, for example of active oxide also known as tunnel oxide and a first conductive layer, for example of polysilicon, are then formed.

The first conductive layer is etched by means of a second mask, to defined floating gate electrodes of the memory cells 12, 120 of width W1 along a first direction, formed in the first group G1, G3 of active areas.

For example, this second mask has openings of greater dimensions with respect to the first mask, so the width W 1 of the memory cells is greater è than the width D of the active areas.

Nothing prevents other process steps from being carried out to form the floating gate electrodes of the memory cells.

In sequence on the whole semiconductor substrate 11, 110, at least one second dielectric layer, for example interpoly oxide, a second conductive layer, for example of polysilicon, and a third photolithographic mask, are then formed to define gate electrodes of the memory cells 12 in a second direction perpendicular to the first direction.

The second conductive layer, the second dielectric layer, the first conductive layer and the first dielectric layer are then etched in sequence through the third mask until the semiconductor substrate is exposed and the gate electrodes of the memory cells having a length L1 are completed.

In particular, with this latter etching step, in the second conductive layer the word lines 20, 21; 200, 210 of the matrix of memory cells 12, 120 are defined. The portions of word lines 20, 21; 200, 210 aligned to the floating gate electrodes form control gate electrodes of the single memory cells 12, 120.

In particular the -word lines 20, 21; 200, 210 extend in a direction perpendicular to the first direction in correspondence with the active areas of the first Group G1, G3 of the active areas and they are spaced from each other in correspondence with the active areas of the second Group G2, G4 of the active areas.

From the semiconductor substrate 11, 110 portions of the insulating layer are removed being comprised between portions of semiconductor substrate 11, 110 wherein the source regions of the memory cells 12, 120 formed in adjacent active areas will be formed.

A common source region 15, 150 is then formed, for example of the N type, which is shared by first groups 14, 140 of the memory cells 12, 120.

In particular, pairs of cells 12, 120 formed in the same active area 13, 130 and placed symmetrically with respect to the common source region 15, 150 share a same source region, and the source regions of the memory cells 12 of the same first group 14 of memory cells are electrically connected to each other by the common source region 15, 150.

The common source region 15, 50 is also formed by a pad 18, 180 widened in correspondence with this contact region 16, 160 which is self-aligned to the word lines 20, 21; 200, 210.

In particular, the widened pad 18, 180 has a polygonal shape which is distributed inside the contact region 16, 160 and it is in electric contact with active areas inside the contact region 16.

After having formed the drain regions in the memory cells 12, 120, and a premetal dielectric layer, openings are formed in correspondence with the drain regions of the memory cells 12, 120 for forming drain contacts 23, 230. The source contact 17 is then formed inside the contact region 160 and it is aligned to the common source region 15.

In conclusion, the device according to the invention is provided with a contact region 16, 160 which allows to maintain the pitch of the matrix critical masks uniform without requiring a reduction of the minimal dimensions- for each single masking level.

Therefore, according to the invention, the contact region 16, 160 shows a space exactly identical to an integer multiple of the dimension of the matrix cell, i.e. of the pitch X.

Moreover, the formation of active areas being equidistant and having identical dimensions allows to simplify the lithographic definition of the critical masks for forming the memory matrix in correspondence with the contact region, modifying only the interconnection structure without addition of specific process steps and without addition of complexity in the creation of the masks.

The structure here described can be applied to memories with a common source region of the EPROM, Flash EEPROM type with NOR organisation, with single or multi level.

## Claims

1. Non volatile memory device integrated on semiconductor substrate (11, 110) and comprising a matrix of non volatile memory cells (12, 120) organised in rows, called word lines, and columns, called bit lines, the device comprising:
- a plurality of active areas (13, 130) formed on the semiconductor substrate (11, 110) comprising a first and a second group (G1, G2; G3, G4) of active areas,
- said non volatile memory cells (12, 120) being integrated in said first group (G1, G3) of active areas, each non volatile memory cell (12, 120) comprising a source region, a drain region and a floating gate electrode coupled to a control gate electrode, at least one group (14, 140) of said memory cells (12, 120) sharing a common source region (15, 150) integrated on said semiconductor substrate (11, 110),
- wherein said plurality of active areas (13, 130) are equidistant from each other and have a same width (D), and
- wherein a contact region (16, 160) is integrated in said second group (G2, G4) of active areas (13, 130) and is provided with at least one common source contact (17, 170) of said common source region (15, 150), the device being **characterised in that**:
- said contact region (16) is in correspondence with at least three adjacent active areas (13) of said second group (G2) of the active areas (13).

2. Non volatile memory device according to claim 1, **characterised in that** said active areas (13, 130) are strips parallel to each other.

3. Non volatile memory device according to claim 1, **characterised in that** pairs of cells (13, 130) formed in the same active area (13, 130) and arranged symmetrically with respect to the common source region (15, 150) share a same source region, the source regions of the memory cells (13, 130) of said at least one group (14, 140) of memory cells being electrically connected to each other by the common source region (15, 150).

4. Non volatile memory device according to claim 1, **characterised in that** said common source region (15, 150) comprises a widened pad (18, 180) in correspondence with this contact region (16, 160).

5. Non volatile memory device according to claim 1, **characterised in that** said widened pad (18, 180) has the polygonal shape which is distributed inside the contact region (16, 160) and is in electric contact with said active areas (13, 130) of said second group (G2, G4) of active areas (13, 130).

6. Non volatile memory device according to claim 1, **characterised in that** said source contact (17) is then in correspondence with the central active area (13) comprised inside the contact region (16).

7. Non volatile memory device according to claim 1, **characterised in that** said contact region (160) is in correspondence with at least one pair of active areas (130) of the second group (G4) of the active areas (130).

8. Non volatile memory device according to claim 7, **characterised in that** said pair of active areas (130) is short-circuited by a portion (131) of said semiconductor substrate 110 which is comprised there between.

9. Non volatile memory device according to claim 8, **characterised in that** said source contact (170) is in correspondence with said portion (131) of said semiconductor substrate (110) comprised between said pair of adjacent cells (130).

## Patentansprüche

1. Vorrichtung mit nichtflüchtigem Speicher, die auf einem Halbleitersubstrat (11, 110) integriert ist und die eine Matrix von nichtflüchtigen Speicherzellen (12, 120) umfasst, die in Zeilen, genannt Wortlinien, und Spalten, genannt Bitlinien, organisiert sind, wobei die Vorrichtung Folgendes umfasst:
- mehrere aktive Bereiche (13, 130), die auf dem Halbleitersubstrat (11, 110) ausgebildet sind und die eine erste und eine zweite Gruppe (G1, G2; G3, G4) von aktiven Bereichen umfassen,
- wobei die nichtflüchtigen Speicherzellen (12, 120) in der ersten Gruppe (G1, G3) von aktiven Bereichen integriert sind und wobei jede nichtflüchtige Speicherzelle (12, 120) eine Sourcezone, eine Drainzone und eine Floating-Gate-Elektrode, die an eine Steuergate-Elektrode gekoppelt ist, umfasst, wobei wenigstens eine Gruppe (14, 140) der Speicherzellen (12, 120) eine gemeinsame Sourcezone (15, 150) teilt, die auf dem Halbleitersubstrat (11, 110) integriert ist,
- wobei die mehreren aktiven Bereiche (13, 130) in gleichem Abstand voneinander angeordnet sind und eine selbe Breite (D) haben, und
- wobei eine Kontaktzone (16, 160) in der zweiten Gruppe (G2, G4) von aktiven Bereichen (13, 130) integriert und mit wenigstens einem gemeinsamen Sourcekontakt (17, 170) der gemeinsamen Sourcezone (15, 150) ausgestattet ist, wobei die Vorrichtung **dadurch gekennzeichnet ist, dass**
- die Kontaktzone (16) in Übereinstimmung mit wenigstens drei benachbarten aktiven Bereichen (13) der zweiten Gruppe (G2) von aktiven Bereichen (13) ausgebildet ist.

2. Vorrichtung mit nichtflüchtigem Speicher nach Anspruch 1, **dadurch gekennzeichnet, dass** die aktiven Bereiche (13, 130) parallel zueinander verlaufende Streifen sind.

3. Vorrichtung mit nichtflüchtigem Speicher nach Anspruch 1, **dadurch gekennzeichnet, dass** Paare von Zellen (13, 130), die in demselben aktiven Bereich (13, 130) ausgebildet sind und die in Bezug auf die gemeinsame Sourcezone (15, 150) symmetrisch angeordnet sind, dieselbe Sourcezone teilen, wobei die Sourcezonen der Speicherzellen (13, 130) der wenigstens einen Gruppe (14, 140) von Speicherzellen durch die gemeinsame Sourcezone (15, 150) miteinander elektrisch verbunden sind.

4. Vorrichtung mit nichtflüchtigem Speicher nach Anspruch 1, **dadurch gekennzeichnet, dass** die gemeinsame Sourcezone (15, 150) in Übereinstimmung mit der Kontaktzone (16, 160) eine erweiterte Fläche (18, 180) umfasst.

5. Vorrichtung mit nichtflüchtigem Speicher nach Anspruch 1, **dadurch gekennzeichnet, dass** die erweiterte Fläche (18, 180) die polygonale Form hat, die sich innerhalb der Kontaktzone (16, 160) erstreckt, wobei sie mit den aktiven Bereichen (13, 130) der zweiten Gruppe (G2, G4) von aktiven Bereichen (13, 130) elektrisch verbunden ist.

6. Vorrichtung mit nichtflüchtigem Speicher nach Anspruch 1, **dadurch gekennzeichnet, dass** der Sourcekontakt (17) in Übereinstimmung mit dem zentralen aktiven Bereich (13) ist, der innerhalb der Kontaktzone (16) enthalten ist.

7. Vorrichtung mit nichtflüchtigem Speicher nach Anspruch 1, **dadurch gekennzeichnet, dass** die Kontaktzone (160) in Übereinstimmung mit wenigstens einem Paar von aktiven Bereichen (130) der zweiten Gruppe (G4) von aktiven Bereichen (130) ist.

8. Vorrichtung mit nichtflüchtigem Speicher nach Anspruch 7, **dadurch gekennzeichnet, dass** das Paar von aktiven Bereichen (130) durch einen Abschnitt (131) des Halbleitersubstrats (110) kurzgeschlossen ist, der zwischen diesen angeordnet ist.

9. Vorrichtung mit nichtflüchtigem Speicher nach Anspruch 8, **dadurch gekennzeichnet, dass** der Sourcekontakt (170) in Übereinstimmung mit dem Abschnitt (131) des Halbleitersubstrats (110) ist, der zwischen dem Paar benachbarter Zellen (130) angeordnet ist.

## Revendications

1. Dispositif de mémoire non volatile intégré sur un substrat de semi-conducteur (11, 110) et comprenant une matrice de cellules de mémoire non volatile (12, 120) organisées en rangées, appelées lignes de mots, et en colonnes, appelées lignes de bits, le dispositif comprenant :
- une pluralité de zones actives (13, 130) formées sur le substrat de semi-conducteur (11, 110) comprenant un premier groupe et un second groupe (G1, G2 ; G3, G4) de zones actives ;
- lesdites cellules de mémoire non volatile (12, 120) étant intégrées dans ledit premier groupe (G1, G3) de zones actives, chaque cellule de mémoire non volatile (12, 120) comprenant une région de source, une région de drain et une électrode de grille flottante couplée à une électrode de grille de commande, au moins un groupe (14, 140) desdites cellules de mémoire (12, 120) partageant une région de source commune (15, 150) intégrée sur ledit substrat de semi-conducteur (11, 110) ;
- dans lequel ladite pluralité de zones actives (13, 130) sont équidistantes les unes des autres et présentent une même largeur (D) ; et
- dans lequel une région de contact (16, 160) est intégrée dans ledit second groupe (G2, G4) de zones actives (13, 130) et est dotée au moins d'un contact de source commune (17, 170) de ladite région de source commune (15, 150), le dispositif étant **caractérisé en ce que** :
- ladite région de contact (16) se trouve en correspondance avec au moins trois zones actives adjacentes (13) dudit second groupe (G2) de zones actives (13).

2. Dispositif de mémoire non volatile selon la revendication 1, **caractérisé en ce que** lesdites zones actives (13, 130) sont des bandes parallèles les unes aux autres.

3. Dispositif de mémoire non volatile selon la revendication 1, **caractérisé en ce que** des paires de cellules (13, 130) formées dans la même zone active (13, 130) et agencées de manière symétrique par rapport à la région de source commune (15, 150), partagent une même région de source, les régions de source des cellules de mémoire (13, 130) dudit ou desdits groupes (14, 140) de cellules de mémoire étant connectées de manière électrique les unes aux autres par la région de source commune (15, 150).

4. Dispositif de mémoire non volatile selon la revendication 1, **caractérisé en ce que** ladite région de source commune (15, 150) comprend une plage de connexion élargie (18, 180) en correspondance avec cette région de contact (16, 160).

5. Dispositif de mémoire non volatile selon la revendication 1, **caractérisé en ce que** ladite plage de connexion élargie (18, 180) présente une forme polygonale qui est répartie à l'intérieur de la région de contact (16, 160) et se trouve en contact électrique avec lesdites zones actives (13, 130) dudit second groupe (G2, G4) de zones actives (13, 130).

6. Dispositif de mémoire non volatile selon la revendication 1, **caractérisé en ce que** ledit contact de source (17) est ensuite en correspondance avec la zone active centrale (13) comprise à l'intérieur de la région de contact (16).

7. Dispositif de mémoire non volatile selon la revendication 1, **caractérisé en ce que** ladite région de contact (160) est en correspondance avec au moins une paire de zones actives (130) du second groupe (G4) de zones actives (130).

8. Dispositif de mémoire non volatile selon la revendication 7, **caractérisé en ce que** ladite paire de zones actives (130) sont court-circuitées par une partie (131) dudit substrat de semi-conducteur (110) qui est comprise entre elles.

9. Dispositif de mémoire non volatile selon la revendication 8, **caractérisé en ce que** ledit contact de source (170) est en correspondance avec ladite partie (131) dudit substrat de semi-conducteur (110) comprise entre ladite paire de cellules adjacentes (130).
